# EUROPÄISCHE PATENTSCHRIFT

(11) **EP 0 505 981 B1**
(45) Veröffentlichungstag und Bekanntmachung des Hinweises auf die Patenterteilung: **10.06.1998**
(21) Anmeldenummer: 92105051.4
(22) Anmeldetag: 24.03.1992
(51) Int. Cl.: G01R 31/26, G01R 31/30, G01R 31/28, H01L 21/00, G01R 1/04

(54) **Anordnung zur Prüfung von Halbleiter-Wafern oder dergleichen**
Semiconductor wafer testing device
Dispositif d'essai de wafers semi-conducteurs

(30) Priorität: 26.03.1991 DE 4109908
(43) Veröffentlichungstag der Anmeldung: 30.09.1992
(73) Patentinhaber: Reitinger, Erich, D-82110 Germering (DE)
(72) Erfinder: Reitinger, Erich, D-82110 Germering (DE)
(74) Vertreter: Reinhard - Skuhra - Weise & Partner

(56) Entgegenhaltungen:
- EP-A- 0 341 156
- DE-A- 3 914 699
- FR-A- 2 645 679
- US-A- 3 710 251
- US-A- 4 607 220
- US-A- 4 845 426
- US-A- 5 084 671

## Beschreibung

Die Erfindung betrifft eine Anordnung zur Prüfung von insbesondere Halbleiter-Wafern oder Hybridschaltungen.

Die Prüfung von Halbleiter-Wafern wird in Temperaturbereichen von -200° C bis +400° C durchgeführt. Diese Temperaturwerte werden durch Kühlung und/oder Beheizung eines Probertisches durchgeführt, auf dem die Halbleiter-Wafer zu Prüfzwecken aufgelegt werden. Im Bereich um und unter 0° C werden auf den Wafern sowie auf den Probertischen selbst Eiskristalle erzeugt, die sich infolge der Feuchtigkeit der Umgebungsluft ergeben. Zur Vermeidung derartiger Eiskristalle wird bei manuell bedienbaren Probern ein Stickstoffstrahl auf den Prober gerichtet. Bei dieser Methode wird zwar im Kernbereich des Stickstoffstrahles die Erzeugung von Eiskristallen verhindert, jedoch wird durch das Ansaugen der Umgebungsluft an den Randbereichen des Stickstoffstrahles auf den Halbleiter-Wafern eine Eiskristallbildung nicht verhindert.

EP-A- 0 341 156 beschreibt eine Anordnung zur Lagerung von Halbleitern, die mit Leitungen versehen ist, um einen Unterdruck zum Zwecke der Halterung der Halbleiterelemente auf der Platte dadurch zu ermöglichen, daß durch diesen Unterdruck die Wafer im Bereich der kreisförmigen Aussparungen auf der Platte angesaugt werden. Die kreisförmigen Aussparungen sind dabei mit den Leitungen verbunden. Ferner sind Leitungen vorhanden, die mit Kanälen verbunden sind, welche sich innerhalb der Platte befinden. Über diese Leitungen wird zur Kühlung oder Erwärmung ein Fluid mit positiver oder negativer Temperaturen zu den Kanälen geführt.

Der Erfindung liegt die Aufgabe zugrunde, eine Anordnung der eingangs genannten Art derart auszubilden, daß im Betrieb bei Temperaturen um und unter 0° C die Erzeugung von Eiskristallen verhindert wird und daß im Betrieb oberhalb von 0°C Beeinträchtigungen durch Staub und/oder Oxidation vermeidbar sind.

Diese Aufgabe wird erfindungsgemäß dadurch gelöst, daß der nach oben offene Behälter durch eine Platte abgedeckt ist, die eine Öffnung zur Durchführung von Sonden enthält, und daß innerhalb des Behälters Ausströmelemente vorgesehen sind, die über eine Verbindung an eine Quelle für Luft oder Gas angeschlossen sind und einen schwachen Luft- oder Gasstrom in Richtung der Öffnung erzeugen, wobei die Luft- oder Gasströmung gleichmäßig aus der Öffnung austritt.

Die Erfindung schafft eine Anordnung zur Prüfung von Halbleiter-Wafern, mit der bei einer Kühlung durch den Probertisch auf Temperaturen um oder unter 0° C die Erzeugung von Eiskristallen verhindert wird, ferner bei Temperaturen oberhalb von 0° C Reinraumbedingungen einhaltbar sind und bei speziellen Anwendungszwecken Oxidationserscheinungen an den Spitzen der Sonden verhindert werden können.

Bei der erfindungsgemäßen Anordnung ist der Probertisch innerhalb eines nach oben offenen Behälters angeordnet, wobei der Probertisch entweder zusammen mit dem Behälter oder relativ zum Behälter in einer horizontalen Ebene verfahrbar ist. Der nach oben offene Behälter ist durch eine Platte mit einer Öffnung abgeschlossen, wodurch der Probertisch innerhalb eines durch den Behälter und die Platte definierten Raumes angeordnet ist. Durch die Plattenöffnung kontaktieren Sonden die zu prüfenden Halbleiter-Wafer. Zur Vermeidung von Eiskristallbildung und/oder des Eindringens von Staubpartikeln wird über innerhalb des Behälters liegende Ausströmelemente ein Gas bzw. Luft mit der erforderlichen Temperatur und/oder dem gewünschten Taupunkt in den Behälter geleitet. Die Strömungsgeschwindigkeit ist derart gewählt, daß eine laminare Strömung gewährleistet ist und eine vorbestimmte Menge an durch die Plattenöffnung austretender Luft erreicht wird.

Gemäß einer bevorzugten Ausführungsform der erfindungsgemäßen Anordnung bestehen die Ausströmelemente aus porösen Körpern, beispielsweise in Form von zylinderischen Rohren, deren Porösität derart gewählt ist, daß das Gas oder die Luft gleichmäßig über die gesamte Länge der Ausströmelemente in den Innenraum des Behältern austritt und dadurch Turbulenzen innerhalb des Behälters vermieden werden.

Im folgenden wird eine bevorzugte Ausführungsform der erfindungsgemäßen Anordnung anhand der Zeichnung zur Erläuterung weiterer Merkmale beschrieben. Es zeigen:
- Figur 1: eine schematische, teilweise im Schnitt gehaltene Ansicht der Anordnung, und
- Figur 2: eine schematische Teilaufsicht auf die Anordnung entlang der Linie 2 - 2'in Figur 1.

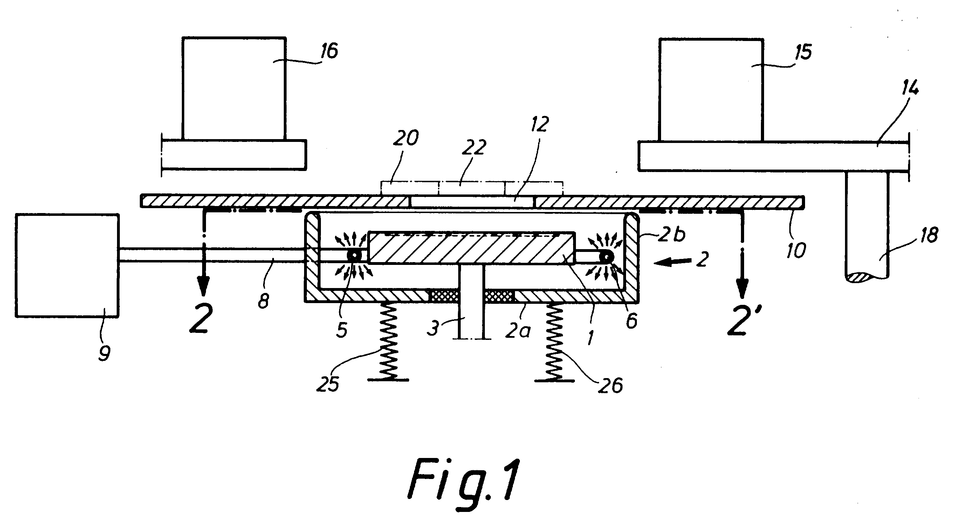

Figur 1 zeigt in schematischer Darstellung eine Anordnung zur Prüfung von Halbleiter-Wafern, Hybridschaltungen oder dergleichen, mit einem Probertisch 1, der zur Aufnahme von Halbleiter-Wafern dient und in bekannter Weise an seiner Oberfläche mit schmalen, vorzugsweise kreisförmigen verlaufenden Nuten ausgebildet ist, die über ein nicht angezeigtes Anschlußsystem dazu dienen, einen Unterdruck gegenüber dem aufgelegten Halbleiter-Wafer auszuüben und den Halbleiter-Wafer auf dem Probertisch 1 zu halten. Der Probertisch 1 ist ferner mit Elementen zur Heizung und/oder Kühlung ausgerüstet. Ein derartiger Probertisch 1 ist sowohl in horizontaler Ebene, d. h. in X- und Y-Richtung verfahrbar, wie auch in einer vertikalen Richtung verlagerbar. Gemäß der dargestellten Ausführungsform der Anordnung ist an der Lagerung 3 des Probertisches 1 eine oben offener Behälter 2 befestigt, der gemäß dieser Ausführungsform zusammen mit dem Probertisch 1 verfahrbar ist und aus einem Boden 2a sowie vier Seitenwänden 2b besteht. Die Seitenwände 2b haben eine Höhe, derart, daß der Probertisch 1 innerhalb dieses Behälters 2 zu liegen kommt und die Oberfläche des Probertisches 1 unterhalb der oberen Kanten der Seitenwände 2b zu liegen kommt. Zwischen der mit 3 bezeichneten Lagerung des Probertisches 1 und dem Boden 2a ist eine geeignete Dichtung angeordnet, die in Figur 1 nicht gezeigt ist und ein Ausströmen des im Behälter 2 befindlichen Gases oder Luft nach unten ausschließt.

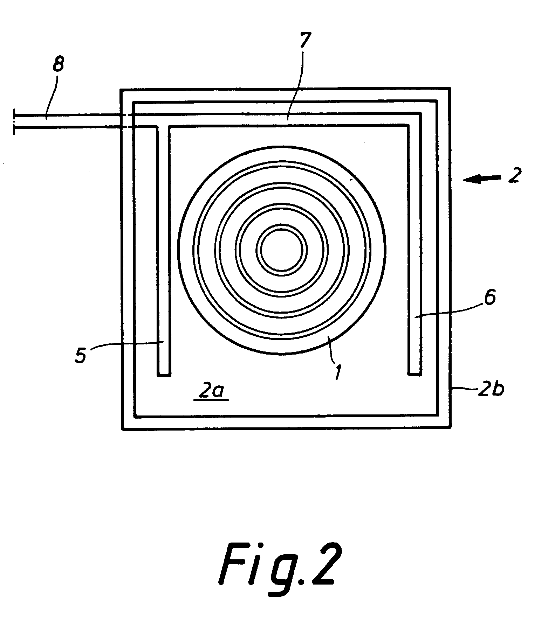

Seitlich des Probertisches 1 sind z. B. in zueinander paralleler Anordnung Ausströmelemente 5, 6 vorgesehen, die über einen Verbindungsabschnitt 7 (Fig. 2) miteinander in Verbindung stehen und über einen Anschluß 8 an eine Quelle 9 angeschlossen sind. Die Quelle 9 erzeugt das Gas, das in das Innere des Behälters 2 geleitet wird, um eine laminare Strömung zu erzeugen. Der Anschluß 8 ist, wie Figur 2 zeigt, durch eine der Seitenwände 2b durchgeführt, derart, daß der Anschluß 8 gegenüber der betreffenden Seitenwand 2b zur Vermeidung eines Austritts von Luft oder Gas abgedichtet ist. Die Ausströmelemente 5, 6 können gegenüber dem Boden 2a oder den Seitenwänden 2b des Behälters 2 durch Halteklammern oder dergleichen fixiert sein.

Die Oberseite des nach oben offenen Behälters 2 ist durch eine Platte 10 abgedeckt, die eine mittige Öffnung 12 enthält, die vorzugsweise kreisförmige Gestalt hat und mittig gegenüber der Mitte des ebenfalls kreisförmigen Probertisches 1 ausgerichtet ist. Die Platte 10, beispielsweise aus Blech, ist gegenüber der gesamten Anordnung fixiert, so daß der Probertisch 1 gemäß dieser Ausführungsform zusammen mit dem Behälter 2 in horizontaler Richtung gegenüber der Platte 10 und einer Sondenhalterung 14 verstellbar ist.

Die Sondenhalterung 14 wie auch der Probertisch 1 mit seiner Lagerung 3 sind gegenüber einem nicht gezeigten Rahmen gelagert, wobei die Sondenhalterung 14 durch mehrere Säulenführungen gegenüber dem Rahmen 1, gegebenenfalls verstellbar, gelagert ist. Die Säulenführungen der Sondenhalterung 14 sind in Figur 1 mit 18 bezeichnet. Auf der Sondenhalterung 14 sind mehrere Sonderhalter 15, 16 montiert, die ihrerseits die zu benutzenden und in Figur 1 nicht gezeigten Sonden aufnehmen.

Die Öffnung 12 der Platte 10 ist derart konzipiert, daß die von den Sondenhaltern 15, 16 gelagerten Sonden einen Spitzenkontakt zu den zu prüfenden Halbleiter-Wafern ermöglichen. Im Bedarfsfall kann die Öffnung 12 durch einen Ring 20, beispielsweise aus Plexiglas, abgeschlossen werden, der eine ebenfalls vorzugsweise kreisförmige Öffnung 22 enthält, welche kleiner ist als die Öffnung 12. Der Ring 20 hat dabei einen Außendurchmesser, der geringfügig größer ist als der Durchmesser der Öffnung 12.

Mittels des Ringes 20, der entweder auf der Platte 10 aufliegt oder in eine ringförmige Nut der Platte 10 im Bereich deren Öffnung 12 eingesetzt wird, die seitlich der Öffnung 12 ausgebildet ist, wird eine Verringerung des Querschnittes der Öffnung 12 im Bedarfsfalle erreicht.

Bei der in Figur 1 und 2 gezeigten Ausführungsform ist eine Verstellung des Probertisches 1 gegenüber der Sondenhalterung 14 und den in den Sondenhaltern 15, 16 eingespannten Sonden möglich, um ein schrittweises Abtasten der auf dem Probertisch 1 aufliegenden Halbleiter-Wafern zu realisieren. Gemäß der dargestellten Ausführungsform wird der Probertisch 1 zusammen mit dem Behälter 2 in X- und Y-Richtung verstellt, um die Prüfung der einzelnen Halbleiter-Wafer zu ermöglichen, die auf einer Trägerschicht angeordnet sind.

Durch die Ausströmelemente 5, 6 wird eine Strömung innerhalb des Behälters 2 erzeugt, die gleichmäßig aus den Ausströmelementen 5, 6 austritt und eine nicht turbulente Luftströmung innerhalb des Behälters 2 erzeugt. Hierdurch wird ein schwacher Luftstrom oder Gasstrom in Richtung der Öffnung 12 erzeugt, wobei diese Luft- oder Gasströmung gleichmäßig aus der Öffnung 12 austritt. Dadurch wird der Eintritt von Umgebungsluft oder von Partikeln aus der Umgebung in das Innere des Behälters 2 verindert.

Als Ausströmelemente 5, 6 dienen vorzugsweise zylinderische Rohre, beispielsweise aus Keramik, Kunststoff oder Kunstfaser, mit einer Porendichte in Größenordnung von 1 bis 30 µm. Diese rohrförmigen Ausströmelemente 5, 6 sind gemäß Figur 2 an der Seite mit ihrem freistehenden Ende abgeschlossen, wodurch das Ausströmen von Luft oder Gas im wesentlichen in Radialrichtung zu den Ausströmelementen 5, 6 gewährleistet ist. Untersuchungen haben gezeigt, daß bei einer Anordnung mit dem vorstehend beschriebenen Aufbau stets eine konstante Luftvolumenemission aus der Öffnung 12 gegeben ist, wobei die Luft nur geringfügig abgekühlt wird, nachdem sie an der Oberfläche der zu prüfenden Halbleiter-Wafer passiert ist. Unterhalb des Probertisches 1 ist ebenfalls ein durch den Probertisch 1 hervorgerufener Kühleffekt festzustellen, wobei die Temperatur allerdings im Vergleich zu der durch die Ausströmelemente 5, 6 zugeführten, getrockneten Luft bei einer Oberflächentemperatur des Probertisches 1 von etwa - 55° C nur verhältnismäßig niedriger ist als die durch die Ausströmelemente 5, 6 zugeführte Lufttemperatur von beispielsweise 20° C. Damit beschränkt sich bei der beschriebenen Anordnung der Kühleffekt des Probertisches 1 vorteilhafterweise nur auf die zu prüfenden Halbleiter-Wafer, während andere Teile innerhalb des Raumes des Behälters 2 durch die Kühlung des Probertischs 1 nicht beaufschlagt werden.

Der vom Probertisch 1 erzeugte Unterdruck zur Halterung der Halbleiter-Wafer ist im Vergleich zu dem von den Ausströmelementen 5, 6 zugeführten Luftvolumen vernachlässigbar und beeinträchtigt nicht die innerhalb des Behälters 2 gewünschte laminare Luftströmung.

Somit konzentriert sich die Kühlung aufgrund des Probertisches 1 bei der beschriebenen Anordnung auf die aufgelegten Halbleiter-Wafer, der übrige Aufbau verbleibt weitgehend auf derjenigen Temperatur, die der Temperatur der durch die Ausströmelemente 5, 6 zugeführten Luft entspricht.

Die erfindungsgemäße Anordnung läßt sich auch zur Einhaltung von Reinraumbedingungen einsetzen, d. h. für die Prüfung von Halbleiter-Wafern bei Temperaturen oberhalb von 0° C, z. B. bei Raumtemperatur. Bei dieser Anwendungsart wird Luft mit der jeweils gewünschten Partikelreinheit in den Behälter 2 eingeführt und es wird verhindert, daß von oben über die Öffnung 12 Schmutzpartikel in den Behälter 2 eintreten. Bei Anwendung der beschriebenen Anordnung unter Reinraumbedingungen bedarf es nicht unbedingt des Einsatzes reiner Luft, jedoch der Zuführung von gefilterter Luft.

Eine weitere Anwendung der beschriebenen Anordnungen liegt in der Überprüfung von Halbleiter-Wafern bei höheren Temperaturen. Bei höheren Temperaturen können an den Nadelspitzen Oxidationen auftreten. Unter Einsatz der erfindungsgemäßen Anordnung läßt sich dies dadurch verhindern, daß durch die Ausströmelemente 5, 6 ein Edelgas (z. B. Argon oder Stickstoff) in den Innenraum des Behälters 2 geleitet wird und dadurch die Prüfspitzen der von den Haltern 15, 16 gehalterten Sonden sich stets in einem Edelgasstrom befinden und dadurch Oxidationen, die zu Fehlmessungen führen, verhindert werden.

Wird die erfindungsgemäße Anordnung in Verbindung mit getrockneter Luft verwendet, deren Taupunkt beispielsweise bei -60° C liegt, kann es erforderlich sein, in dem Behälter 2 eine Ionisationseinrichtung vorzusehen, um die zu den Ausströmelementen 5, 6 geführte Luft vor deren Eintriff in den Behälter 2 zu ionisieren. Die Ionisierung der Luft hat den Zweck, einen Funkenüberschlag innerhalb des Behälters 2 bei der Überprüfung der Halbleiter-Wafer zu vermeiden.

Gemäß einer weiteren, in den Zeichnungen nicht dargestellten Ausführungsform der erfindungsgemäßen Anordnung ist vorgesehen, daß der Probertisch 1 relativ zum Behälter 2 verstellbar, insbesondere in X-Y-Richtung verstellbar ist. Um dies zu erreichen, ist der Boden 2 mit einer entsprechend großen Öffnung versehen, wobei innerhalb der Öffnung des Bodens 2a um die Lagerung 3 eine flexible Dichtung eingesetzt ist, um die Verstellung der Lagerung 3 relativ zum Boden 2a zu realisieren.

Um den Behälter 2 gegen die Unterfläche der Platte 10 zu halten, sind bei der in Figur 1 gezeigten Ausführungsform Federeinrichtungen 25, 26 vorgesehen, die eine Vorspannungskraft erzeugen und die oberen Kanten der Behälterwände 2b gegen die untere Fläche der Platte 10 drücken.

Um eine ruckfreie Verschiebung des Behälters 2 gegenüber der Platte 10 zu vermeiden, d. h. um den Reibungswiderstand zwischen den oberen Kanten der Seitenwände 2b und der Platte 10 weitgehend zu reduzieren, sind bei einer bevorzugten Ausführungsform die nach oben weisenden Kanten der Seitenwände 2b abgerundet. Anstelle der Abrundungen der Kanten der Seitenwände 2b können zusätzliche Gleitelemente, z.B. die Kanten von oben eingesetzten Gleitstiften, vorgesehen werden.

Zur besseren Einsicht in den Behälter 2 besteht dieser vorzugsweise aus Plexiglas.

Figur 2 zeigt nur eine mögliche Ausführungsform der Ausströmelemente 5, 6, die im wesentlichen parallel zueinander liegend angeordnet sind und durch ein Verbindungsrohr 7 eine im wesentliche U-förmige oder ringförmige Struktur ergeben. Anstelle des Verbindungsrohres 7 kann ein entsprechendes Ausströmelement vorgesehen sein, das mit den anderen Ausströmelementen 5, 6 verbunden ist.

Die erfindungsgemäße Anordnung läßt sich in der nachstehenden Weise verwenden:

Bei Prüfvorgängen in Temperaturbereichen von -200° C bis +400° C, die vom Probertisch 1 an seiner Oberfläche gegenüber den aufliegenden Halbleiter-Wafern erzeugt werden, wird zur Vermeidung von Eiskristallbildung von der Quelle 9 eine Luftströmung erzeugt, die beispielsweise eine Temperatur von 20° C hat und einen Taupunkt bei ungefähr -60° C besitzt.

Bei der erfindungsgemäßen Anordnung, die sich insbesondere für manuell bedienbare Prober eignet, läßt sich der wannenförmige Behälter 2 soweit in der horizontalen Ebene verschieben, daß er durch Verlagerung gegenüber der oben liegenden Platte 10 nach Art einer Schubladenfunktion den Zugang auf den Probertisch 1 ermöglicht, um ein Auswechseln der Halbleiter-Wafer zu ermöglichen.

Bei der Überprüfung von Wafern können Sonden in Form von Prüfnadeln und/oder Nadelkanten zum Kontaktieren der Wafer, Hybridschaltungen oder dergleichen eingesetzt werden.

## Patentansprüche

1. Anordnung zur Prüfung von insbesondere Halbleiter-Wafern oder Hybridschaltungen, mit einem Probertisch (1) zur Aufnahme der zu prüfenden Halbleiter-Wafer oder Hybridschaltungen, mit einer Halterung (14) zur Aufnahme von Haltern (15, 16) für Sonden, wobei der Probertisch (1) innerhalb eines Behälters (2) angeordnet ist, der nach oben offen ausgebildet ist;
der nach oben offene Behälter (2) durch eine Platte (10) abgedeckt ist, die eine Öffnung (12) zur Durchführung von Sonden enthält;
innerhalb des Behälters (2) Ausströmelemente (5, 6) vorgesehen sind, die über eine Verbindung (8) an eine Quelle (9) für Luft oder Gas angeschlossen sind und einen schwachen Luft- oder Gasstrom in Richtung der Öffnung (12) erzeugen, wobei die Luft- oder Gasströmung gleichmäßig aus der Öffnung (12) austritt.

2. Anordnung nach Anspruch 1, dadurch gekennzeichnet, daß der Behälter (2) fest mit dem Probertisch (1) verbunden ist.

3. Anordnung nach Anspruch 1, dadurch gekennzeichnet, der Probertisch (1) gegenüber dem Behälter (2) verstellbar angeordnet ist.

4. Anordnung nach wenigstens einem der vorangehenden Ansprüche, dadurch gekennzeichnet, daß die Ausströmelemente (5, 6) aus einem porösen Material bestehen, derart, daß im Behälter (2) eine laminare Luftströmung oder Gasströmung erzeugt wird.

5. Anordnung nach wenigstens einem der vorangehenden Ansprüche, dadurch gekennzeichnet, daß die Quelle (9) an welche die Ausströmelemente (5, 6) angeschlossen sind, Luft mit ca. 20° C und einem Taupunkt bei -196° C erzeugt.

6. Anordnung nach einem der Ansprüche 1 bis 4, dadurch gekennzeichnet, daß gefilterte Luft zu den Ausströmelementen (5, 6) geführt wird.

7. Anordnung nach einem der Ansprüche 1 bis 4, dadurch gekennzeichnet, daß von der Quelle (9) Edelgas zu den Ausströmelementen (5, 6) geleitet wird.

8. Anordnung nach wenigstens einem der vorangehenden Ansprüche, dadurch gekennzeichnet, daß im Behälter (2) eine Einrichtung zur Ionisierung der Luft vorgesehen ist.

## Claims

1. Arrangement for testing semi-conductor wafers or hybrid circuits in particular, the arrangement comprising a sampler table (1) for holding the semi-conductor wafers or hybrid circuits to be tested, and a mounting (14) for holding probe holders (15, 16), wherein the sampler table (1) is disposed inside a container (2) which is formed such that it is open at the top; the container (2) that is open at the top is covered by a plate (10) which has an opening (12) through which probes pass; provided inside the container (2) are discharge elements (5, 6) which are connected to an air or gas source (9) via a connection (8) and generate a weak air or gas flow in the direction of the opening (12), the air or gas flow emerging uniformly from the opening (12).

2. Arrangement according to Claim 1, characterized in that the container (2) is rigidly connected to the sampler table (1).

3. Arrangement according to Claim 1, characterized in that the sampler table (1) is disposed so as to be displaceable relative to the container (2).

4. Arrangement according to at least one of the preceding claims, characterized in that the discharge elements (5, 6) consist of a porous material such that a laminar air flow or gas flow is generated in the container (2).

5. Arrangement according to at least one of the preceding claims, characterized in that the source (9) to which the discharge elements (5, 6) are connected generates air having a temperature of approximately 20°C and a dew point of -196°C.

6. Arrangement according to any one of Claims 1 to 4, characterized in that filtered air is fed to the discharge elements (5, 6).

7. Arrangement according to any one of Claims 1 to 4, characterized in that inert gas is fed from the source (9) to the discharge elements (5, 6).

8. Arrangement according to at least one of the preceding claims, characterized in that an air-ionization device is provided in the container (2).

## Revendications

1. Dispositif pour tester notamment des pastilles semiconductrices ou des circuits hybrides, comportant une table de test (1) servant à recevoir les pastilles semiconductrices ou les circuits hybrides à tester, un dispositif de retenue (14) servant à recevoir des supports (15,16) pour des sondes, dans lequel la table de test (1) est disposée à l'intérieur d'un récipient (2), qui est ouvert vers le haut;
le récipient (2) ouvert vers le haut est recouvert par une plaque (10), qui contient une ouverture (12) pour le passage de sondes;
à l'intérieur du récipient (2) sont prévus des organes de sortie (5,6), qui sont raccordés par l'intermédiaire d'une liaison (8) à une source (9) pour de l'air ou du gaz et produisent un courant d'air ou de gaz faible en direction de l'ouverture (12), le courant d'air ou de gaz sortant d'une manière uniforme par l'ouverture (12).

2. Dispositif selon la revendication 1, caractérisé en ce que le récipient (2) est relié de façon fixe à la table de test (1).

3. Dispositif selon la revendication 1, caractérisé en ce que la table de test (1) est disposée de manière à être déplaçable par rapport au récipient (2).

4. Dispositif selon au moins l'une des revendications précédentes, caractérisé en ce que les éléments de sortie (5,6) sont constitués d'un matériau poreux de telle sorte qu'un courant d'air ou un courant de gaz laminaire est produit dans le récipient (2).

5. Dispositif selon au moins l'une des revendications précédentes, caractérisé en ce que la source (9), à laquelle les éléments de sortie (5,6) sont raccordés, produit de l'air à une température d'environ 20°C et avec un point de rosée à -196°C.

6. Dispositif selon l'une des revendications 1 à 4, caractérisé en ce que l'air filtré est envoyé aux éléments de sortie (5,6).

7. Dispositif selon l'une des revendications 1 à 4, caractérisé en ce qu'un gaz rare est guidé depuis la source (9) jusqu'aux éléments de sortie (5,6).

8. Dispositif selon au moins l'une des revendications précédentes, caractérisé en ce qu'un dispositif d'ionisation de l'air est prévu dans le récipient (2).
